# EUROPEAN PATENT APPLICATION

(11) **EP 4 113 134 A1**
(43) Date of publication of application: **04.01.2023**
(21) Application number: 22181126.8
(22) Date of filing: 25.06.2022
(51) Int. Cl.: G01R 31/00, G01R 31/327, G01R 31/333, B60L 3/00, B60L 3/04, H01H 9/28, H01H 47/00

(54) **CONTACTOR WELDING DIAGNOSIS DEVICE**

(30) Priority: 28.06.2021 JP 2021106630
(71) Applicant: Suzuki Motor Corporation, Hamamatsu-shi, Shizuoka 432-8611 (JP); DENSO CORPORATION, Kariya-city, Aichi 448-8661 (JP)
(72) Inventor: KOBUNA, Shingo, Hamamatsu-shi, 432-8611 (JP); OKAWACHI, Ryohei, Hamamatsu-shi, 432-8611 (JP); NISHI, Kohei, Kariya-City, 448-8661 (JP)
(74) Representative: Haseltine Lake Kempner LLP

(57) **Abstract**

[Object]

It is to provide a contactor welding diagnosis device capable of avoiding an erroneous contactor welding determination even when a motor rotates during a contactor welding diagnosis.

[Solution]

A contactor welding diagnosis device includes: a high-voltage battery 4 as a main power source; an inverter 3 to drive a motor 2 with electric power supplied from the high-voltage battery 4 thereto; a negative electrode side contactor 41 and a positive electrode side contactor 42 to electrically connect/disconnect the high-voltage battery 4 and the inverter 3 to/from each other; and a contactor welding diagnosis unit 5 to switch the contactor between the connection/disconnection to thereby diagnose whether the negative electrode side contactor 41 and the positive electrode side contactor 42 are welded based on a change of an applied voltage to the inverter 3 at the switching, when starting the vehicle 1, the contactor welding diagnosis unit switching the contactor to the disconnection when a rotation speed of the motor 2 reaches a first rotation speed or higher.

## Description

### [Technical Field]

This invention relates to a contactor welding diagnosis device.

### [Background of the Invention]

Patent Literature 1 discloses a method of diagnosing, at a timing of outputting an instruction for starting a vehicle, welding abnormality of one of a negative electrode contactor and a positive electrode side contactor with a positive electrode contactor and a precharge contactor, and diagnosing, at a timing of outputting another instruction for stopping the vehicle, welding abnormality of the other of the negative electrode contactor and the positive electrode side contactor.

For the diagnosis of the welding abnormality of the contactor, there is known a method in which it is diagnosed whether positive and negative electrode side contactors are welded based on a voltage fluctuation when one or both of them are turned on/off.

In this method, when, at starting the vehicle, turning off the positive electrode side contactor and turning on the negative electrode side contactor, it is determined that the positive electrode side contactor is welded if a voltage between terminals of positive and negative electrodes in the inverter increases, for example.

### [Prior Art]

### [Patent Literature]

[Patent Literature 1] JP 2013-169087 A

### [Summary of the Invention]

### [Problem to be solved by the Invention]

However, in such a welding abnormality diagnosis method, in a case where a motor rotates during the contactor welding diagnosis, a voltage of which an applying direction is opposite to that of a voltage applied from a high-voltage battery is to be applied due to a counter electromotive force of the motor. Due thereto, for example, even though the negative electrode side contactor is welded, the voltage between the terminals in the inverter may not increase to a voltage value for determining the welding, causing erroneous determination that the welded contactor is normal.

For example, at starting the vehicle on a slope, when the motor rotates while being dragged by a driving wheel due to the vehicle sliding down, such a phenomenon occurs. Additionally, if the vehicle brakes the driving wheel by only a side brake without a parking lock function, such an event is likely to occur.

Thus, an object of this invention is to provide a contactor welding diagnosis device capable of avoiding an erroneous contactor welding determination even when a motor rotates during a contactor welding diagnosis.

### [Means to solve the problem]

According to an aspect of this invention, there is provided a contactor welding diagnosis device of a vehicle including a high-voltage battery as a main power source, an inverter to drive a motor with electric power supplied from the high-voltage battery thereto, and a contactor to electrically connect/disconnect the high-voltage battery and the inverter to/from each other, the contactor welding diagnosis device including a contactor welding diagnosis unit to switch, when starting the vehicle, the contactor between the connection and the disconnection to thereby diagnose whether the contactor is welded based on a change of an applied voltage to the inverter at the switching, wherein the contactor welding diagnosis unit switches the contactor to the disconnection when a rotation speed of the motor reaches a first rotation speed or higher during the diagnosing.

### [Effect of the Invention]

In this way, according to this invention, it is possible to avoid the erroneous determination of the welding of the contactor even when the motor rotates during the contactor welding diagnosis.

### [Brief description of figures]

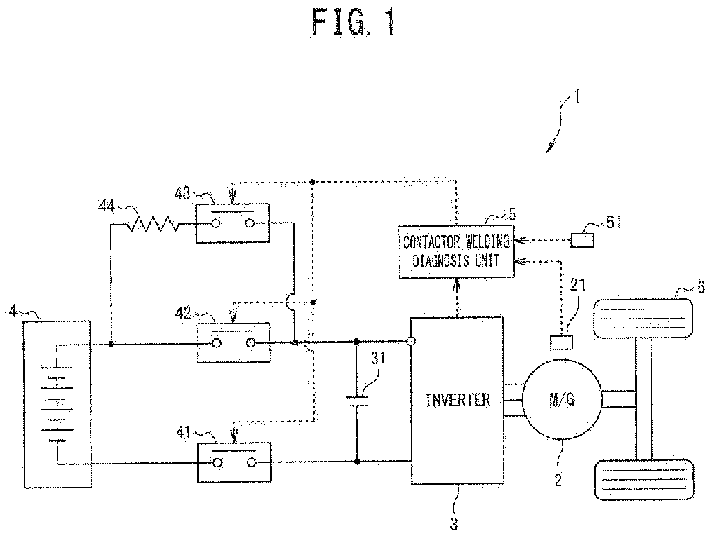

Fig. 1 is a schematic configuration diagram of a contactor welding diagnosis device according to an embodiment of this invention.

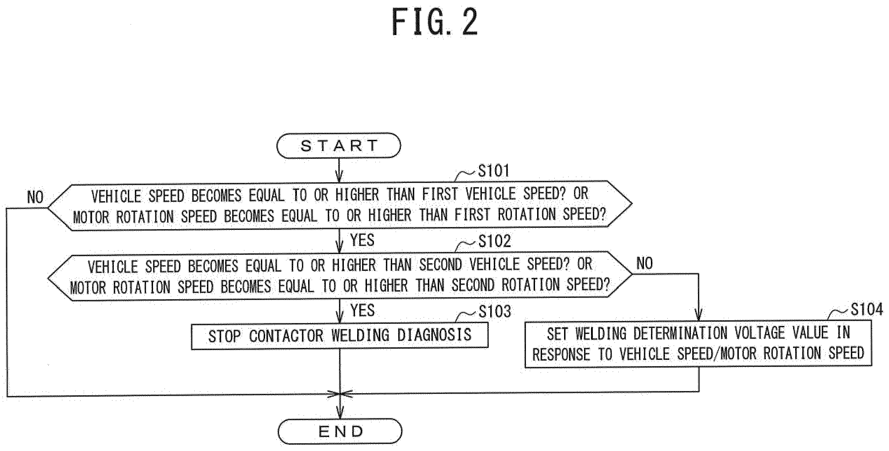

Fig. 2 is a flowchart showing a procedure of a welding diagnosis determination process to be performed in a contactor welding diagnosis device according to another embodiment of this invention.

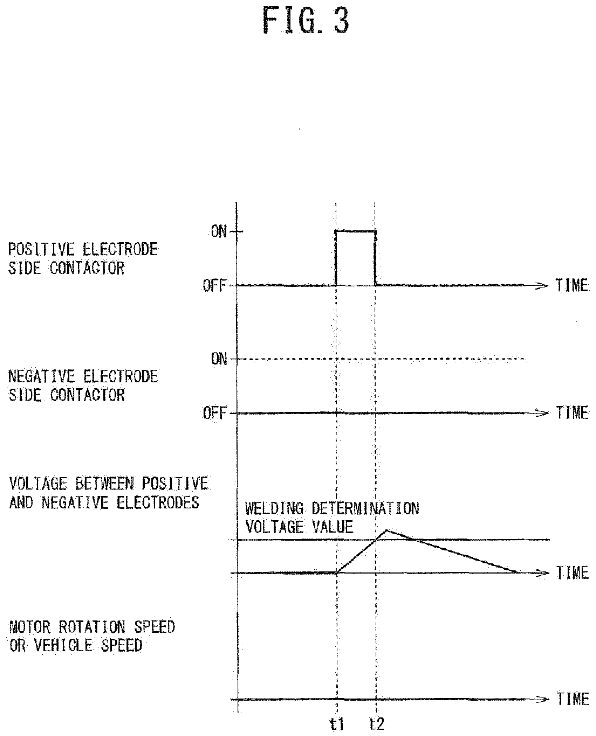

Fig. 3 is a timing chart showing a relationship between a voltage across a positive electrode and a negative electrode and a welding determination voltage value in a case where the welding diagnosis determination process is performed in the contactor welding diagnosis device according to the another embodiment when there is no counter electromotive voltage of a motor with the negative electrode side contactor welded.

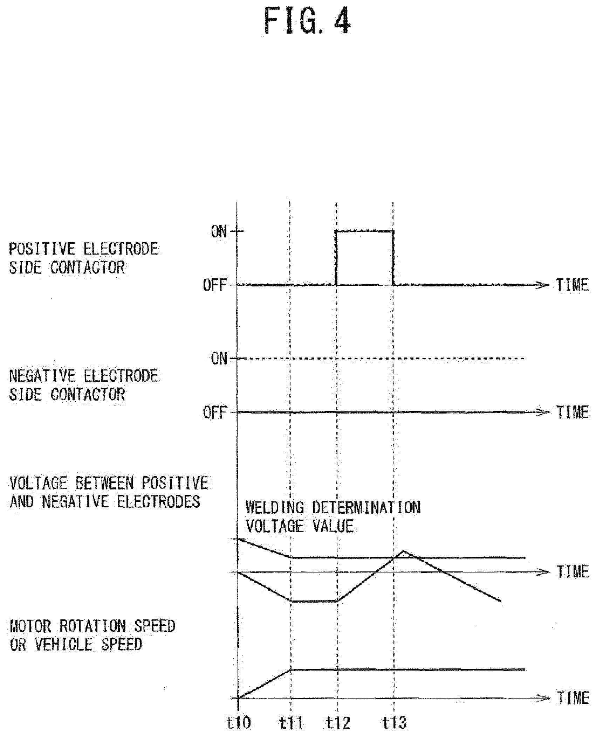

Fig. 4 is a timing chart showing a voltage across a positive electrode and a negative electrode and a change in a welding determination voltage value in a case where the welding diagnosis determination process is performed in the contactor welding diagnosis device according to the another embodiment of this invention when there is counter electromotive voltage of a motor with the negative electrode side contactor welded.

### [Embodiment(s) of the Invention]

A contactor welding diagnosis device according to an embodiment of this invention is mounted on a vehicle including a high-voltage battery as a main power source, an inverter to drive a motor with electric power supplied from the high-voltage battery thereto, and a contactor to electrically connect/disconnect the high-voltage battery and the inverter to/from each other, the contactor welding diagnosis device including a contactor welding diagnosis unit to switch, when starting the vehicle, the contactor between the connection and the disconnection to thereby diagnose whether the contactor is welded based on a change of an applied voltage to the inverter at the switching, wherein the contactor welding diagnosis unit switches the contactor to the disconnection when a rotation speed of the motor reaches a first rotation speed or higher during the diagnosing.

Accordingly, the contactor welding diagnosis device can avoid an erroneous determination of the welding of the contactor even when the motor rotates during the contactor welding diagnosis.

### [Embodiments]

Hereinafter, a contactor welding diagnosis device according to an embodiment of this invention will be described in detail with reference to the drawings.

As shown in Fig. 1, a vehicle 1 mounted with a contactor welding diagnosis device according to an embodiment of this invention includes a motor 2, an inverter 3, a high-voltage battery 4, and a contactor welding diagnosis unit 5.

The motor 2 is constituted of a synchronous motor including a rotor in which a plurality of permanent magnets are embedded and a stator around which coil is wound, for example. In the motor 2, a rotating magnetic field is generated in the stator by applying three-phase AC power to the stator coil, and the rotor rotates by the generated rotating magnetic field to thereby generate a driving force.

Furthermore, the motor 2 is driven to brake the vehicle 1 using the rotational resistance during power generation. That is, the motor 2 has a function of generating electric power by regeneration. In this way, the motor 2 functions also as a generator to thereby generate electric power for charging the high-voltage battery 4.

The rotation shaft of the motor 2 is connected to driving wheels 6 through a speed reducer, driving shafts, and the like (not shown), to drive the driving wheels 6 therethrough.

The motor 2 is provided with a rotation speed sensor 21 which detects the rotation speed of the motor 2.

The rotation speed sensor 21 outputs e.g., the rotation speed as a positive rotation with which the vehicle 1 moves forward (i.e., outputs the rotation speed with positive value in a case where the vehicle 1 moves forward).

The inverter 3 supplies three-phase AC power to the motor 2. Additionally, the inverter 3 converts the three-phase AC power generated by the motor 2 into DC power and charges the high-voltage battery 4 therewith.

A smoothing capacitor 31 is connected between input terminals of positive and negative electrodes to interconnect the inverter 3 and the high-voltage battery 4. The smoothing capacitor 31 smooths the voltage of the DC power generated between the positive and negative electrodes.

The high-voltage battery 4, such as a nickel storage battery or a lithium storage battery, is constituted of a plurality of cells interconnected in series. The high-voltage battery 4 supplies electric power to the motor 2 via the inverter 3.

A contactor 41 (also referred to as "negative electrode side contactor 41") is provided at a negative electrode side between the inverter 3 and the high-voltage battery 4. A contactor 42 (also referred to as "positive electrode side contactor 42") is provided at a positive electrode side between the inverter 3 and the high-voltage battery 4. A precharge contactor 43 and a precharge resistance 44 in series are connected to the positive electrode side contactor 42 in parallel.

The negative and positive electrode side contactors 41, 42 are each switched between an on state (connection state) where the inverter 3 and the high-voltage battery 4 are electrically connected to each other and an off state (disconnection state) where the inverter 3 and the high-voltage battery 4 are electrically disconnected from each other, in response to the control of the contactor welding diagnosis unit 5.

The precharge contactor 43 is switched between an on state where the precharge resistance 44 is connected to the positive electrode side contactor 42 in parallel or an off state where the precharge resistance 44 is electrically disconnected from the positive electrode side contactor 42, in response to the control of the contactor welding diagnosis unit 5.

For example, the precharge contactor 43 is controlled so as to be turned on before the motor 2 is operated and to be turned off after the positive electrode side contactor 42 is turned on.

The contactor welding diagnosis unit 5 is composed of a computer unit including a CPU (Central Processing Unit), a RAM (Random Access Memory), a ROM (Read Only Memory), an input port, and an output port.

The ROM of the contactor welding diagnosis unit 5 stores a program allowing the computer unit to function as the contactor welding diagnosis unit 5 together with various control constants and various maps. That is, when the CPU executes the program stored in the ROM, the computer unit functions as the contactor welding diagnosis unit 5.

Various sensors including a vehicle speed sensor 51 are connected to the input port of the contactor welding diagnosis unit 5 in addition to the inverter 3 and the rotation speed sensor 21 described above. The vehicle speed sensor 51 detects the speed of the vehicle 1.

On the other hand, various control targets including the negative electrode side contactor 41, the positive electrode side contactor 42, and the precharge contactor 43 described above are connected to the output port of the contactor welding diagnosis unit 5.

In the embodiment, the contactor welding diagnosis unit 5 performs a contactor welding diagnosis of diagnosing whether or not the respective negative and positive electrode side contactors 41, 42 are welded.

The contactor welding diagnosis unit 5 performs the contactor welding diagnosis for the negative electrode side contactor 41 and the positive electrode side contactor 42, when starting the vehicle 1 (i.e., when activating the vehicle).

For example, when one of the negative and positive electrode side contactors 41, 42 is controlled to be turned on (i.e., when the contactor welding diagnosis unit 5 sends a command for turning on to the one contactor and sends a command for turning off to the other contactor), if a voltage between the input terminals of the positive and negative electrodes in the inverter 3, i.e. a voltage applied to the inverter 3, exceeds a predetermined welding determination voltage value, the contactor welding diagnosis unit 5 determines that the other contactor which receives the command for turning off is welded.

When the motor rotation speed becomes equal to or higher than a predetermined first rotation speed during the contactor welding diagnosis, the contactor welding diagnosis unit 5 stops the contactor welding diagnosis and turns off the negative and positive electrode side contactors 41, 42. The first rotation speed is a lower-limit value of the motor rotation speed at which a counter electromotive voltage from the motor 2 that influences the contactor welding diagnosis is generated and is, for example, 100 rpm.

When the speed of the vehicle 1 becomes equal to or higher than a predetermined first vehicle speed during the contactor welding diagnosis, the contactor welding diagnosis unit 5 stops the contactor welding diagnosis and turns off the negative and positive electrode side contactors 41, 42. The first vehicle speed is a lower-limit value of the vehicle speed at which a counter electromotive voltage from the motor 2 that influences the contactor welding diagnosis is generated and is, for example, 1 km/h.

In this way, in the embodiment, when the motor rotation speed reaches the first rotation speed or higher during the contactor welding diagnosis, the contactor welding diagnosis unit 5 turns off the negative and positive electrode side contactors 41, 42.

That is, in a case where there is possibility that the contactor welding diagnosis is not normally performed due to the counter electromotive voltage generated by the rotation of the motor 2, the contactors are turned off and the start of the vehicle 1 is stopped.

Thus, it is possible to avoid that the welding of the contactor is incorrectly determined and the vehicle 1 is allowed to be started.

Additionally, when the speed of the vehicle 1 reaches the first vehicle speed or higher during the contactor welding diagnosis, the contactor welding diagnosis unit 5 turns off the negative and positive electrode side contactors 41, 42.

In such a case, since driving wheels 6 and the motor 2 are interconnected to rotate together, a vehicle speed exceeding zero leads to the rotation of the motor 2 by which the counter electromotive voltage is generated. In this case, a current flowing from the inverter 3 toward the high-voltage battery 4 is generated when the negative and positive electrode side contactors 41, 42 are turned on, causing the manner of change of the voltage between the input terminals in the inverter 3 to be different from that in the normal case. Hence, there is possibility that the start of vehicle 1 is completed without detecting welded contactor to thereby allow the vehicle 1 to run with the welded contactor. Thus, in a case where the counter electromotive voltage is supposed to be generated with respect to the contactor, the contactors are turned off, avoiding the erroneous determination of the welding of the contactor.

As another embodiment of the present invention, during the contactor welding diagnosis, in a case where the counter electromotive voltage of the motor 2 is supposed to be generated e.g., when the speed of the vehicle 1 reaches the first vehicle speed or the motor rotation speed reaches the first rotation speed, the contactor welding diagnosis unit 5 performs the diagnosis using a welding determination voltage value in response to the speed of the vehicle 1 or the motor rotation speed.

The welding determination voltage value is set to a lower value as the speed of the vehicle 1 becomes higher or as the motor rotation speed becomes higher.

When the speed of the vehicle 1 reaches the second vehicle speed higher than the first vehicle speed during the contactor welding diagnosis, the contactor welding diagnosis unit 5 stops the contactor welding diagnosis and turns off the negative and positive electrode side contactors 41, 42.

Additionally, when the motor rotation speed reaches the second rotation speed higher than the first rotation speed during the contactor welding diagnosis, the contactor welding diagnosis unit 5 stops the contactor welding diagnosis and turns off the negative and positive electrode side contactors 41, 42.

A welding diagnosis determination process to be performed by the contactor welding diagnosis device according to the another embodiment will be described with reference to Fig. 2. Note that the welding diagnosis determination process to be described below is started upon start of the contactor welding diagnosis, being performed at a predetermined time interval, being stopped when the contactor welding diagnosis ends.

In step S101, the contactor welding diagnosis unit 5 determines whether the speed of the vehicle 1 reaches the first vehicle speed and whether the motor rotation speed reaches the first rotation speed. Note that either one of the speed of the vehicle 1 and the motor rotation speed may be used for the determination.

If "YES" in step S101, i.e., if it is determined that the speed of the vehicle 1 reaches the first vehicle speed or the motor rotation speed reaches the first rotation speed, the contactor welding diagnosis unit 5 performs the process of step S102. Otherwise, i.e., if it is determined that neither of the speed of the vehicle 1 and the motor rotation speed reaches the first vehicle speed/the first rotation speed, the contactor welding diagnosis unit 5 ends the welding diagnosis determination process.

In step S102, the contactor welding diagnosis unit 5 determines whether the speed of the vehicle 1 reaches the second vehicle speed and/or whether the motor rotation speed reaches the second rotation speed.

If "YES" in step S102, i.e., if it is determined that the speed of the vehicle 1 reaches the second vehicle speed and/or the motor rotation speed reaches the second rotation speed, the contactor welding diagnosis unit 5 performs the process of step S103. Otherwise, i.e., if it is determined that the speed of the vehicle 1/the motor rotation speed does not reach the second vehicle speed/the second rotation speed, the contactor welding diagnosis unit 5 performs the process of step S104.

In step S103, the contactor welding diagnosis unit 5 stops the contactor welding diagnosis and turns off the negative and positive electrode side contactors 41, 42. After the process of step S103 is performed, the contactor welding diagnosis unit 5 ends the welding diagnosis determination process.

In step S104, the contactor welding diagnosis unit 5 sets the welding determination voltage value in response to the vehicle speed/the motor rotation speed. After the process of step S104 is performed, the contactor welding diagnosis unit 5 ends the welding diagnosis determination process.

Examples where such a welding diagnosis determination process is performed will be described with reference to Figs. 3 and 4. Fig. 3 is a timing chart showing a change of a voltage between the input terminals of the positive and negative electrodes in the inverter 3 when there is no counter electromotive voltage of the motor 2. Note that, in FIG. 3, a case is shown in which the negative electrode side contactor 41 is welded.

In the drawing, the respective solid lines of the positive electrode side contactor and the negative electrode side contactor indicate control state and on the other hand, the respective dotted lines thereof indicate actual state. That is, the negative electrode side contactor 41 is, as the solid line, in an off state in terms of control (i.e., the contactor welding diagnosis unit 5 sends a command for turning off the negative electrode side contactor 41 thereto), but actually is, as the dotted line, in an on state since it is welded.

Upon turning on the positive electrode side contactor 42 for the contactor welding diagnosis at the time t1, the voltage value between the positive and negative electrodes increases since the negative electrode side contactor 41 is welded. Subsequently, at the time t2, since the voltage value reaches the welding determination voltage value, it is determined that the negative electrode side contactor 41 is welded.

Fig. 4 is a timing chart showing a change of a voltage between the input terminals of the positive and negative electrodes in the inverter 3 when there is the counter electromotive voltage of the motor 2 due to rotation of the driving wheels 6. Note that, also in FIG. 4, a case is shown in which the negative electrode side contactor 41 is welded.

Similarly to Fig. 3, in FIG. 4, the respective solid lines of the positive electrode side contactor and the negative electrode side contactor indicate control state and on the other hand, the dotted lines thereof indicate actual state. That is, the negative electrode side contactor 41 is in an off state in terms of control, but actually is in an on state since it is welded.

The motor rotation speed/the vehicle speed begins to increase at the time t10, the counter electromotive voltage is generated in the motor 2 by the rotation of the motor 2, and the counter electromotive voltage of the motor 2 also increases as the rotation of the motor 2 continuously increases until the time t11. Therewith, the welding determination voltage value decreases. That is, the welding determination voltage value decreases as the motor rotation speed/the vehicle speed increases.

Upon turning on the positive electrode side contactor 42 for the contactor welding diagnosis at the time t12, the voltage value between the positive and negative electrodes increases since the negative electrode side contactor 41 is welded. Subsequently, at the time 13, since the voltage value reaches the welding determination voltage value, it is determined that the negative electrode side contactor 41 is welded. Specifically, although the voltage value decreases from the time t10 to the time t12 due to the counter electromotive voltage of the motor 2 (i.e., the voltage value at the time 13 in FIG. 4 is lower, by the decreased amount, than that in FIG. 3 (a case where there is no counter electromotive voltage)), the welding determination voltage value is decreased so as to cancel the decreased amount, preventing an erroneous determination due to the counter electromotive voltage of the motor 2.

In this way, it is possible to normally perform, by properly changing the welding determination voltage value, the contactor welding diagnosis even when the counter electromotive voltage of the motor 2 is generated.

Thus, in the another embodiment, the contactor welding diagnosis unit 5 changes, during the contactor welding diagnosis, the welding determination voltage value in response to the speed of the vehicle 1 or the motor rotation speed if the speed of the vehicle 1 reaches the first vehicle speed or if the motor rotation speed reaches the first rotation speed.

Due thereto, the welding determination voltage value is set to a value in response to the speed of the vehicle 1/the motor rotation speed, normally performing the contactor welding diagnosis even when the counter electromotive voltage of the motor 2 is generated.

Additionally, the welding determination voltage value is set to be lower one as the speed of the vehicle 1 becomes higher. Similarly, the welding determination voltage value is set so, as the motor rotation speed becomes higher.

Due thereto, the welding determination voltage value can be set to a proper one in consideration of the counter electromotive voltage of the motor 2, normally performing the contactor welding diagnosis even when the counter electromotive voltage of the motor 2 is generated.

Furthermore, during the contactor welding diagnosis, if the speed of the vehicle 1 reaches the second vehicle speed or the motor rotation speed reaches the second rotation speed, the contactor welding diagnosis unit 5 stops the contactor welding diagnosis and turns off both the negative electrode side contactor 41 and the positive electrode side contactor 42.

In such a case, the counter electromotive voltage of the motor 2 is supposed to be too high, where the voltage between the input terminals in the inverter 3 may be too low to thereby disenable the contactor welding diagnosis to be easily performed. Then, both of the contactors are controlled to be turned off and thus, even if one of the contactors is welded, the other contactor not welded is actually turned off to thereby electrically disconnect the battery 4 and the inverter 3 from each other, surely avoiding the vehicle 1 from running with the welded contactor.

In the embodiments, an example in which the contactor welding diagnosis unit 5 performs various determinations or calculations on the basis of various sensor information has been described, but this invention is not limited thereto. For example, the vehicle 1 may include a communication unit capable of communicating with an external device such as an external server, perform various determinations or calculations by the external device on the basis of detection information of various sensors transmitted from the communication unit, receive the determination result or calculation result by the communication unit, and perform various controls using the received determination result or calculation result.

While embodiments of this invention have been described, it is apparent that some artisan could have made changes without departing from the scope of this invention. It is intended that any and all such modifications and equivalents are involved in the appended claims.

### (DESCRIPTION OF REFERENCE NUMERALS)

1: Vehicle
2: Motor
3: Inverter
4: High-voltage battery
5: Contactor welding diagnosis unit
6: Driving wheel
21: Rotation speed sensor
41: Negative electrode side contactor (contactor)
42: Positive electrode side contactor (contactor)
43: Precharge contactor
44: Precharge resistance
51: Vehicle speed sensor

## Claims

1. A contactor welding diagnosis device of a vehicle (1), the vehicle including a high-voltage battery (4) as a main power source, an inverter (3) to drive a motor (2) with electric power supplied from the high-voltage battery thereto, and a contactor (41, 42) to electrically connect/disconnect the high-voltage battery and the inverter to/from each other, the contactor welding diagnosis device comprising:
a contactor welding diagnosis unit (5) to switch, when starting the vehicle, the contactor between the connection and the disconnection to thereby diagnose whether the contactor is welded based on a change of an applied voltage to the inverter at the switching,
wherein the contactor welding diagnosis unit switches the contactor to the disconnection when a rotation speed of the motor reaches a first rotation speed or higher during the diagnosing.

2. The contactor welding diagnosis device according to claim 1,
wherein if the applied voltage to the inverter reaches a welding determination voltage value during the diagnosing, the contactor welding diagnosis unit determines that the contactor is welded, the contactor welding diagnosis unit setting the welding determination voltage value in response to the rotation speed of the motor.

3. The contactor welding diagnosis device according to claim 2,
wherein the contactor welding diagnosis unit sets the welding determination voltage value to a lower value as the rotation speed of the motor becomes higher.

4. The contactor welding diagnosis device according to claim 2 or 3,
wherein the contactor welding diagnosis unit switches the contactor to the disconnection if the rotation speed of the motor reaches, during the diagnosing, a second rotation speed higher than the first rotation speed.

5. The contactor welding diagnosis device according to claim 1,
wherein the motor is connected to a driving wheel (6) to drive the vehicle, the motor rotating together with the driving wheel, and
wherein the contactor welding diagnosis unit switches the contactor to the disconnection when a speed of the vehicle reaches a first vehicle speed or higher during the diagnosing.

6. The contactor welding diagnosis device according to claim 5,
wherein if the applied voltage to the inverter reaches a welding determination voltage value during the diagnosing, the contactor welding diagnosis unit determines that the contactor is welded, the contactor welding diagnosis unit setting the welding determination voltage value in response to the speed of the vehicle.

7. The contactor welding diagnosis device according to claim 6,
wherein the contactor welding diagnosis unit sets the welding determination voltage value to a lower value as the speed of the vehicle becomes higher.

8. The contactor welding diagnosis device according to claim 6 or 7,
wherein the contactor welding diagnosis unit switches the contactor to the disconnection if the speed of the vehicle reaches, during diagnosing, a second vehicle speed higher than the first vehicle speed.
